# EUROPÄISCHE PATENTANMELDUNG

(11) **EP 1 067 673 A2**
(43) Veröffentlichungstag der Anmeldung: **10.01.2001**
(21) Anmeldenummer: 00113818.9
(22) Anmeldetag: 29.06.2000
(51) Int. Cl.: H03D 7/14

(54) **Mischer mit einstellbarer Linearität**

(30) Priorität: 30.06.1999 DE 19930152
(71) Anmelder: Infineon Technologies AG, 81541 München (DE)
(72) Erfinder: Ganser, Siegfried, 85570 Markt Schwaben (DE); Catala, Stephane, 85737 Ismaning (DE)
(74) Vertreter: Zedlitz, Peter, Dipl.-Inf.

(57) **Zusammenfassung**

Ein Vierquadranten-Multiplizierer zum Mischen von HF-Signalen, der eine modifizierte Gilbert-Zelle darstellt, weist zwei Differenzverstärker (T1, T2, bzw. T3, T4) auf, die jeweils als Last eines dritten Differenzverstärkers (T7, T8) geschaltet sind. Die Gegenkopplung des dritten Differenzverstärkers wie auch die Last können verändert werden. Durch Änderung der Gegenkopplung kann der Linearitätsbereich des durch den Vierquadranten-Multiplizierer gebildeten Mischers einstellbar gewählt werden.

## Beschreibung

Die vorliegende Erfindung bezieht sich allgemein auf Mischer und genauer gesagt auf einen Vierquadranten-Multiplizierer zum Mischen von HF-Signalen. Üblicherweise ist eines der zugeführten HF-Signale ein empfangenes, moduliertes HF-Signal und das andere HF-Signal ein Lokaloszillator-Ausgangssignal mit einer festen Referenzfrequenz. Durch den Mischer wird das empfangene, modulierte HF-Signal auf eine Zwischenfrequenz ZF herabgesetzt.

Zu dem oben genannten Zweck ist es notwendig, daß für beide zugeführte HF-Signale sowohl positive wie auch negative Vorzeichen zulässig sind. Ein Mischertyp, der dieser Anforderung entspricht ist der sogenannte Vierquadranten-Multiplizierer, der auch Gilbert-Zelle genannt wird. Figur 2 zeigt ein solches Beispiel einer bekannten Gilbert-Zelle, wie sie aus der US-A-5,826,182 bekannt ist. Diese in Figur 2 dargestellte Zelle weist drei Differenzverstärker auf, wobei ein erster Differenzverstärker T1, T2 und ein zweiter Differenzverstärker T3, T4 jeweils als Last eines dritten Differenzverstärkers T7, T8 geschaltet sind.

Das empfangene, modulierte HF-Signal wird dem dritten Differenzverstärker T7, T8 und genauer gesagt den Basisanschlüssen der Transistoren T7, T8 zugeführt. Das HF-Signal von einem Lokaloszillator mit fester Referenzfrequenz wird den Basis-Anschlüssen der Transistoren T1, T2 bzw. T3, T4 des ersten bzw. zweiten Differenzverstärkers zugeführt. Alternativ kann natürlich auch das empfangene, modulierte HF-Signal dem ersten und zweiten und das HF-Signal von dem Lokaloszillator dem dritten Differenzverstärker zugeführt werden. Emitterseitig ist eine gemeinsame Stromquelle I für die Transistoren T7, T8 vorgesehen.

Das Zwischenfrequenzsignal kann dann an Additionspunkten der Kollektoren von kreuzweise verbundenen Transistoren T1, T2, T3, T4 des ersten und zweiten Differenzverstärkers abgegriffen werden.

Beispielsweise aus Tietze, Schenk 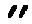 Halbleiterschaltungstechnik", 9. Auflage, Springer-Verlag, 1991, Seite 351 ff. ist es bekannt, die Emitter der Transistoren T7, T8 mit einem Gegenkopplungswiderstand zu verbinden und jeweils eine Stromquelle für jeden der Transistoren T7, T8 vorzusehen.

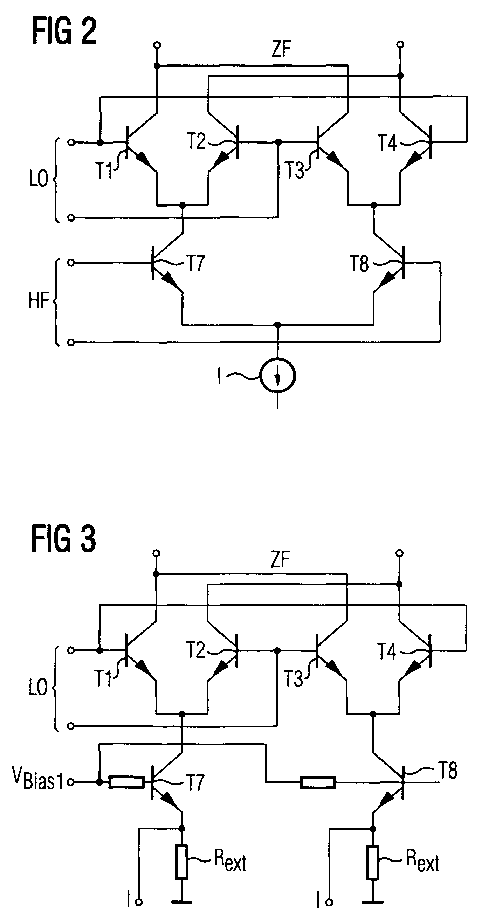

Eine wichtige Kennzeichnung eines derartigen Mischers ist seine Linearität, das heißt der Spannungsbereich der Eingangssignale, in dem der Mischer ein weitgehend lineares Verhalten zeigt. Der erforderliche Linearitätsbereich hängt von der Art der Anwendung ab. Zur Einstellung des Linearitätsbereichs von derartigen Mischern ist es beispielsweise bekannt, ihn extern durch zusätzliche Widerstände zur Stromerhöhung einzustellen. Eine derart modifizierte Gilbert-Zelle ist in Figur 3 dargestellt. Die emitterseitig an den Transistoren T7, T8 vorgesehenen externen Widerstände sind dabei mit Rₑₓₜ bezeichnet. Weiterhin werden die Steueranschlüsse der Transistoren T7, T8 mit einer Biasspannung V_{BIAS1} zur Arbeitspunkteinstellung beaufschlagt. Die Transistoren T1, T2, T3, T4 der ersten Differenzverstärkerstufe werden ebenfalls mit einer nicht gezeigten Biasspannung zur Arbeitspunkteinstellung beaufschlagt.

Indessen bestehen bei dieser externen Widerstandsschaltung zur Linearitätsbereichs-Einstellung Probleme. Durch den immer höher werdenden Integrationsgrad und die Verwendung von beispielsweise Spiegelfrequenz-Unterdrückungsmischern auf integrierten Schaltungen wird heutzutage der Ausgang eines Verstärkers mit geringem Rauschen (LNA) direkt mit dem Mischereingang verbunden, was bedeutet, daß das durch den LNA verstärkte Empfangssignal die integrierte Schaltung nicht mehr verläßt. Schaltungstechnisch bedeutet dies bspw., daß nun nicht mehr die Emitter des Mischers als Eingang verwendet werden, sondern die Basis.

Ausgehend von diesem Stand der Technik ist es Aufgabe der vorliegenden Erfindung, eine Technik bereitzustellen, die Mischer mit einstellbarem Linearitätsbereich ermöglicht.

Diese Mischer sollten möglichst auch vollkommen integrierbar sein, was bei dem Stand der Technik mit externen Widerständen nicht der Fall ist.

Die Aufgabe wird erfindungsgemäß durch die Merkmale des Anspruchs 1 gelöst. Die abhängigen Ansprüche bilden den zentralen Gedanken der Erfindung in besonders vorteilhafter Weise weiter.

Erfindungsgemäß ist also ein Vierquadranten-Multiplizierer zum Mischen von HF-Signalen vorgesehen. Der Vierquadranten-Multiplizierer weist zwei Differenzverstärker auf, die als Last für einen dritten Differenzverstärker geschaltet sind. Der erste und der zweite Differenzverstärker dienen zur Eingabe eines ersten HF-Signals und der dritte Differenzverstärker zur Eingabe eines zweiten HF-Signals auf. Das erste HF-Signal kann beispielsweise ein HF-Signal mit Referenzfrequenz von einem Lokaloszillator sein. Das zweite HF-Signal ist in diesem Fall ein verstärktes, moduliertes Empfangssignal.

Gemäß der vorliegenden Erfindung ist wenigstens ein einstellbares Widerstandselement vorgesehen, das die Kollektoren von Transistoren des ersten und zweiten Differenzverstärkers und/oder die Emitter von Transistoren des dritten Differenzverstärkers verbindet.

Das wenigstens eine einstellbare Widerstandselement kann ein einstellbares Gegenkopplungs-Widerstandselement sein, das jeweils zwischen einer Stromquelle und einem Emitter von Transistoren des dritten Differenzverstärkers geschaltet ist.

Es kann weiterhin wenigstens ein einstellbares Widerstandselement als einstellbares Laständerungs-Widerstandselement vorgesehen sein, das jeweils zwischen den Kollektoren der Transistoren des ersten und zweiten Differenzverstärks angeschlossen ist.

Es können Mittel zum synchronen Schalten des einstellbaren Gegenkopplungs-Widerstandselements und des einstellbaren Laständerungs-Widerstandselements vorgesehen sein.

Das synchrone Schalten des einstellbaren Gegenkopplungs-Widerstandselements und des einstellbaren Laständerungs-Widerstandselements kann durch einen Bus gesteuert werden.

Eines von einstellbarem Gegenkopplungs-Widerstandselement und einstellbarem Laständerungs-Widerstandselement kann ein p-Kanal Transistor und das jeweils andere ein n-Kanal Transistor sein.

Weiterhin kann ein festes Gegenkopplungs-Widerstandselement vorgesehen sein, das nicht einstellbar ist und das jeweils zwischen der Stromquelle und den Emittern von Transistoren des dritten Differenzverstärkers angeschlossen ist.

Der Widerstandswert des wenigstens einen einstellbaren Widerstandselements kann zumindest in einem vorgegebenen Bereich kontinuierlich geändert werden, was bspw. durch Realisierung mit einem Transistor erreicht werden kann.

Gemäß der vorliegenden Erfindung ist weiterhin ein Empfänger für modulierte HF-Signale vorgesehen, der einen Vierquadranten-Multiplizierer nach einem der vorhergehenden Ansprüche aufweist. Dabei wird den Steuereingängen des ersten und zweiten Differenzverstärkers ein verstärktes, moduliertes HF-Signal mittels eines Verstärkers mit geringem Rauschen (LNA) zugeführt. Den Steuereingängen des dritten Differenzvers wird ein HF-Signal von einem Lokaloszillator mit fester Referenzfrequenz F_{REF} zugeführt (oder umgekehrt).

Weitere Aufgaben, Merkmale und Eigenschaften der vorliegenden Erfindung werden aus der nun folgenden Beschreibung eines Ausführungsbeispiels bezugnehmend auf die Figuren der begleitenden Zeichnungen näher ersichtlich.
Figur 1 zeigt das Schaltbild eines erfindungsgemäßen Mischers,
Figur 2 zeigt einen aus dem Stand der Technik bekannten Mischer, der Vierquadranten-Multiplizierer oder auch Gilbert-Zelle genannt wird, und
Figur 3 eine modifizierte Gilbert-Zelle.

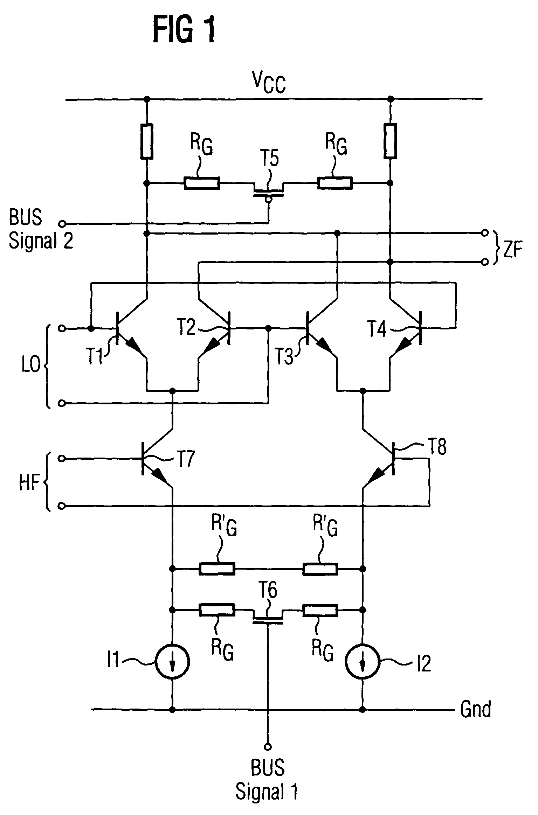

Ähnlich wie die aus dem Stand der Technik bekannten Mischer gemäß Figur 2 weist der in Figur 1 dargestellte Mischer, der ebenfalls ein Vierquadranten-Multiplizierer ist, einen ersten Differenzverstärker mit Transistoren T1, T2 und einen zweiten Differenzverstärker T3, T4 auf, die jeweils als Last eines dritten Differenzverstärkers T7, T8 geschaltet sind.

Den Steuereingängen (Basis im Fall der dargestellten Bipolar-Transistoren) der Transistoren des ersten und zweiten Differenzverstärkers wird ein Referenzsignal von einem Lokaloszillator (LO) zugeführt. Durch dieses Referenzsignal soll ein empfangenes, moduliertes HF-Signal, das den Steuereingängen der Transistoren T7, T8 des dritten Differenzverstärkers zugeführt wird, auf eine Zwischenfrequenz ZF heruntergemischt werden, wobei das Zwischenfrequenzsignal ZF an Additionspunkten von kreuzverbundenen Kollektoren der Transistoren T1, T3 bzw. T2, T4 abgenommen wird.

Zwischen den Emittern der Transistoren T7, T8 des dritten Differenzverstärker und Masse ist jeweils eine Stromquelle I1, I2 geschaltet.

Wie aus Figur 1 ersichtlich sind an mehreren Punkten interne Widerstandselemente vorgesehen. Zum einen sind feste Gegenkopplungswiderstände R_{G}, vorgesehen, die zwischen den Emittern der Transistoren T7 bzw. T8 und den Stromquellen I1 bzw. I2 angeschlossen sind. Durch die Wahl geeigneter Widerstandswerte für die Widerstandselemente R_{G}, und die damit erzeugte Gegenkopplung kann ein vorbestimmter Linearitätsbereich für den Mischer beispielsweise für eine vorbestimmte Anwendung gewählt werden.

Um den Linearitätsbereich beispielsweise für verschiedene Anwendungen veränderbar und insbesondere einstellbar zu machen, ist alternativ oder zusätzlich zu den festen Gegenkopplungs-Widerstandselementen R_{G}, parallel zu diesen ein einstellbares Widerstandselement vorgesehen. Dieses einstellbare Widerstandselement wird durch eine Serienschaltung von Widerständen R_{G} und einem Transistor T6 erreicht. Wie dargestellt kann dieser Transistor T6 beispielsweise ein n-Kanal MOS-FET sein. Durch Ein- bzw. Ausschalten des Transistors T6 kann somit die Gegenkopplung des dritten Differenzverstärkers T7, T8 und durch Änderung der Gegenkopplung somit auch der Linearitätsbereich des Vierquadranten-Multiplizierer insgesamt gewählt werden.

Ein weiteres einstellbares Widerstandselement in Form einer Serienschaltung von Widerständen R_{G} mit einem weiteren Transistor T5 ist als Laständerungs-Widerstandselement zwischen dem ersten und dem zweiten Differenzverstärker vorgesehen. Dieses Laständerungs-Widerstandselement, das somit ebenfalls einstellbar ist, ist jeweils zwischen den Kollektoren der Transistoren T1, T2, T3, T4 des ersten und des zweiten Differenzverstärkers angeschlossen und dient zur Einstellung der Verstärkung. Im Sinne einer CMOS-Implementierung ist der Transistor T5 wie dargestellt beispielsweise ein p-Kanal MOS-FET unter Berücksichtigung, daß der Gegenkopplungs-Schalttransistor T6 ein n-Kanal MOS-FET ist.

Zur Ansteuerung des Schaltvorgangs der beiden Transistoren T5, T6 werden sie über Signale SIGNAL1, SIGNAL2 von einer Busleitung BUS her angesteuert. Der Schaltvorgang kann insbesondere synchron angesteuert und ausgeführt werden.

Bei Vergrößerung des Linearitätsbereichs durch Änderung der Gegenkopplung und der Last der jeweiligen Transistoren T5, T6 wird gleichzeitig natürlich auch das Rauschverhalten des Multiplizierers verschlechtert.

Der Linearitätsbereich des Vierquadranten-Multiplizierer muß insbesondere dann vergrößert werden, wenn neben dem Nutzsignal mit verhältnismäßig kleiner Amplitude auch andere Signale mit großer Amplitude den Steuereingängen des dritten Differenzverstärkers T7, T8 zugeführt werden. Dies ist bei dem GSM-System beispielsweise der Fall, wenn neben dem Nutzsignal mit verhältnismäßig kleiner Amplitude ein sogenanntes Blockersignal, das frequenzmäßig nahe am Nutzsignal liegt, mit sehr hohem Pegel den Steuereingängen der Transistoren des dritten Differenzverstärkers T7, T8 zugeführt wird. Nur durch eine Erhöhung des Linearitätsbereichs des Mischers kann sichergestellt werden, daß sowohl das Nutzsignal mit verhältnismäßig kleiner Amplitude wie auch das Blockersignal mit verhältnismäßig großer Amplitude korrekt verarbeitet werden. Der Mischer soll sich also sowohl für die hohe Amplitude (Pegel) wie auch für die kleine Amplitude linear verhalten.

Zusammengefaßt gesagt kann also mittels eines beispielsweise über einen Dreileiterbus angesteuerten n-Kanal Transistors T6 die Gegenkopplung variiert werden, und damit der Mischer für einen weiteren Betriebsfall optimiert werden.

Dadurch, daß zum Schalten der Gegenkopplung bzw. der Last jeweils ein Transistor verwendet wird, kann auch ein kontinuierlicher Schaltvorgang ausgeführt werden, das heißt im Sinne eines analogen Schalters kann nicht nur zwischen 0 und 1 geschaltet werden, sondern kontinuierlich der Wert der Gegenkopplung durch entsprechende Wahl des Widerstandswerts des Kanals des Transistors verändert werden. In diesem Fall wird den Transistoren T5 und T6 ein analoges Steuersignal zugeführt. Beispielsweise wird das entsprechende Busssignal durch einen D/A-Wandler (nicht gezeigt) digital-analog umgesetzt den Steueranschlüssen der Transistoren T5, T6 zugeführt.

Durch diese stufenlose Einstellbarkeit (im Gegensatz zum Stand der Technik, bei dem diese nur in Sprüngen möglich ist) des Gegenkopplungs-Widerstandswert zumindest über einen bestimmten Bereich läßt sich eine echte Optimierung des Linearitätsbereichs für bestimmte Anwendungen ausführen. Somit kann der Mischer bspw. genau auf die bei einer bestimmten Anwendung zu erwartenden Pegelunterschiede der Eingangssignale eingestellt werden. Dies stellt einen wesentlichen Vorteil im Vergleich zu Schaltern einer reinen 0/1 (auf/zu) Funktion dar.

Vorteilhafterweise können sämtliche Widerstandselemente als integrierte Widerstände ausgebildet werden.

## Patentansprüche

1. Vierquadranten-Multiplizierer zum Mischen von HF-Signalen, aufweisend einen ersten (T1, T2) und einen zweiten Differenzverstärker (T3, T4), die jeweils als Last eines dritten Differenzverstärkers (T7, T8) geschaltet sind, wobei Steueranschlüssen des ersten und zweiten Differenzverstärkers (T1, T2, T3, T4) ein erstes HF-Signal (LO) und Steueranschlüssen des dritten Differenzverstärkers (T7, T8) ein zweites HF-Signal (HF) zugeführt werden,
**dadurch gekennzeichnet**,
daß wenigstens ein einstellbares Widerstandselement (T6, T5, R_{G},) zwischen Kollektoren von Transistoren des ersten und zweiten Differenzverstärkers (T1, T2, T3, T4) und oder zwischen Emittern von Transistoren des dritten Differenzverstärkers (T7, T8) vorgesehen sind.

2. Vierquadranten-Multiplizierer nach Anspruch 1,
dadurch gekennzeichnet,
daß wenigstens ein Widerstandselement ein einstellbares Gegenkopplungs-Widerstandselement (T6) ist, das jeweils zwischen einer Stromquelle (I1, I2) und Emittern von Transistoren des dritten Differenzverstärkers (T7, T8) angeschlossen ist.

3. Vierquadranten-Multiplizierer nach Anspruch 1 oder 2,
dadurch gekennzeichnet,
daß weiterhin wenigstens ein Widerstandselement ein einstellbares Laständerungs-Widerstandselement (T5) vorgesehen ist, das kollektorenseitig den ersten und den zweiten Differenzverstärker miteinander verbindet.

4. Vierquadranten-Multiplizierer nach Anspruch 3,
dadurch gekennzeichnet,
daß Mittel (BUS) zum synchronen Schalten des einstellbaren Gegenkopplungs-Widerstandselements (T6) und des einstellbares Laständerungs-Widerstandselement (T5) vorgesehen sind.

5. Vierquadranten-Multiplizierer nach Anspruch 3 oder 4,
dadurch gekennzeichnet,
daß das synchrone Schalten des einstellbaren Gegenkopplungs-Widerstandselements (T6) und des einstellbares Laständerungs-Widerstandselement (T5) durch einen Bus gesteuert wird.

6. Vierquadranten-Multiplizierer nach einem der Ansprüche 3 bis 5,
dadurch gekennzeichnet,
daß eines von einstellbarem Gegenkopplungs-Widerstandselement (T6) und einstellbarem Laständerungs-Widerstandselement (T5) ein p-Kanal Transistor und das jeweils andere ein n-Kanal Transistor ist.

7. Vierquadranten-Multiplizierer nach einem der vorhergehenden Ansprüche,
dadurch gekennzeichnet,
daß weiterhin wenigstens ein Widerstandselement ein festes Gegenkopplungs-Widerstandselement (R_{G},) ist, das jeweils zwischen der Stromquelle (I1, I2) und den Emittern von Transistoren des dritten Differenzverstärkers (T7, T8) angeschlossen ist.

8. Vierquadranten-Multiplizierer nach einem der vorhergehenden Ansprüche,
dadurch gekennzeichnet,
daß der Widerstandswert des wenigstens einen einstellbaren Widerstandselements (T5, T6) zumindest in einem vorgegebenen Bereich kontinuierlich geändert werden kann.

9. Empfänger für modulierte HF-Signale,
aufweisend einen Vierquadranten-Multiplizierer nach einem der vorhergehenden Ansprüche, wobei ein Verstärker (LNA) vorgesehen ist, der den Steuereingängen des dritten Differenzverstärkers (T7, T8) ein verstärktes moduliertes HF-Signal (HF) zuführt, und den Steuereingängen der ersten und zweiten Differenzverstärkers ein Referenzsignal von einem Lokaloszillator (LO) zugeführt wird bzw. umgekehrt.
